(19)

Europäisches
Patentamt
European
Patent Office
Office européen
des brevets

(11) **EP 4 488 702 A1**

(12) **EUROPEAN PATENT APPLICATION**

(43) Date of publication:
**08.01.2025 Bulletin 2025/02**

(21) Application number: **23204556.7**

(22) Date of filing: **19.10.2023**

(51) International Patent Classification (IPC):
**G01R 33/00** (2006.01)   **G01C 17/38** (2006.01)

(52) Cooperative Patent Classification (CPC):
**G01C 17/38; G01R 33/0035; Y02A 90/30**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **07.07.2023 CN 202310836367**

(71) Applicant: **Beijing Xiaomi Mobile Software Co., Ltd.**
**Beijing 100085 (CN)**

(72) Inventor: **LIANG, Jinpeng**
**Beijing, 100085 (CN)**

(74) Representative: **dompatent von Kreisler Selting Werner -**
**Partnerschaft von Patent- und Rechtsanwälten mbB**
**Deichmannhaus am Dom**
**Bahnhofsvorplatz 1**
**50667 Köln (DE)**

(54) **CALIBRATION METHOD FOR ELECTRONIC COMPASS, ELECTRONIC DEVICE AND MEDIUM**

(57) A calibration method for an electronic compass includes: acquiring (S11) an initial sphere center coordinate of a current calibration; acquiring (S12) a preset number of magnetic field data collected by a magnetic sensor; determining (S13) a target magnetic field interference level of an environment according to the preset number of magnetic field data and the initial sphere center coordinate; determining (S14) a target number of the magnetic field data according to the target magnetic field interference level; and performing (S15) spherical magnetic field fitting according to the target number of magnetic field data to calibrate the electronic compass.

Acquiring an initial sphere center coordinate of a current calibration — S11

Acquiring a preset number of magnetic field data collected by a magnetic sensor — S12

Determining a target magnetic field interference level of an environment according to the preset number of magnetic field data and the initial sphere center coordinate — S13

Determining a target number of the magnetic field data according to the target magnetic field interference level — S14

Performing spherical magnetic field fitting according to the target number of magnetic field data to calibrate the electronic compass — S15

Fig. 1

EP 4 488 702 A1

## Description

### FIELD

The present invention relates to a field of electronic devices, and more particularly to a calibration method for an electronic compass, an electronic device and a medium.

### BACKGROUND

In a compass course measurement technology, a spherical magnetic field in an environment is calculated. The calculated magnetic field primarily depends on an acceleration and magnetic field data collected by a gyroscope and a magnetometer. However, magnetic field interference exists in the environment of the compass. When the magnetic field interference in the environment is serious, the collected magnetic field data is abnormal, and the calculated magnetic field is also an elliptical magnetic field, so that a sphere center of the obtained spherical magnetic field is also abnormal. Thus, a deviation of a course measured by a compass is large and difficult to calibrate.

In a prior art solution, the abnormal elliptical magnetic field is converted into an ideal spherical magnetic field by using parameter fitting, and a sphere center coordinate of the spherical magnetic field is obtained to calculate a direction during use. However, in a magnetic field fitting, the accuracy of the sphere center coordinate of the acquired spherical magnetic field is determined by selection of the magnetic field data, so that the accuracy of the compass course measurement is influenced. Furthermore, the calculation power consumption is also influenced by the selection of the magnetic field data.

### SUMMARY

In order to overcome the problem in the prior art, the present invention provides a calibration method for an electronic compass, an electronic device and a medium.

The present invention is defined in the independent claim 1, and the preferable features according to the present invention are defined in the dependent claims. Any example in the present disclosure that does not fall within the scope of the present invention should be regarded as an example for understanding the present invention.

According to a first aspect of the present invention, there is provided a calibration method for an electronic compass, including: acquiring an initial sphere center coordinate of a current calibration; acquiring a preset number of magnetic field data collected by a magnetic sensor; determining a target magnetic field interference level of an environment according to the preset number of magnetic field data and the initial sphere center coordinate; determining a target number of the magnetic field data according to the target magnetic field interference level; and performing spherical magnetic field fitting according to the target number of magnetic field data to calibrate the electronic compass.

According to a second aspect of the present invention, there is provided an electronic device, including: a processor; and a memory configured to store instructions executable by the processor. The processor is configured to execute the steps of the calibration method for the electronic compass according to the first aspect of the present invention.

According to a third aspect of the present invention, there is provided a computer-readable storage medium storing computer program instructions thereon. When executed by a processor, the program instructions are configured to implement the steps of the calibration method for the electronic compass according to the first aspect of the present invention.

With the above technical solution, firstly, the current target magnetic field interference level of the environment is determined according to the preset number of magnetic field data and the initial sphere center coordinate of the current calibration, and then, the corresponding target number of the magnetic field data is determined according to the target magnetic field interference level, and finally, the spherical magnetic field fitting is performed according to the target number of magnetic field data so as to calibrate the electronic compass. Thus, different numbers of magnetic field data is selected for the spherical magnetic field fitting according to different magnetic field interference levels, reducing a calculation loss. Further, the number of magnetic field data corresponding to the magnetic field interference level is adopted for fitting, which improves the accuracy of the spherical magnetic field fitting, thus improving the calibration efficiency of the electronic compass.

It is to be understood that both the foregoing general description and the following detailed description are illustrative and explanatory only and are not intended to limit the present invention.

### BRIEF DESCRIPTION OF THE DRAWINGS

The accompanying drawings, which are incorporated in and constitute a part of this specification, illustrate examples consistent with the present invention and, together with the description, serve to explain the principles of the present invention.

Fig. 1 shows a flow chart of a calibration method for an electronic compass according to an illustrative example of the present invention.

Fig. 2 shows a flow chart of another calibration method for an electronic compass according to an illustrative example of the present invention.

Fig. 3 shows a block diagram of a calibration apparatus for an electronic compass according to an illustrative example of the present invention.

Fig. 4 shows a block diagram of an electronic device according to an illustrative example of the present invention.

## DETAILED DESCRIPTION

Reference will now be made in detail to illustrative examples, examples of which are illustrated in the accompanying drawings. The following description refers to the accompanying drawings in which the same numbers in different drawings represent the same or similar elements unless otherwise represented. The implementations described in the following illustrative examples do not represent all implementations consistent with the present invention. Instead, they are merely examples of an apparatus and a method consistent with some aspects related to the present invention as recited in the appended claims.

It should be noted that all actions of acquiring signals, information or data in the present invention are performed under the premise of complying with the corresponding data protection regulations and policies of the country where the present invention is and in a case of obtaining an authorization given by an owner of a corresponding apparatus.

In the related art, a certain number of magnetic field data is selected from numerous magnetic field data, and an elliptic magnetic field is fitted into an ideal spherical magnetic field through a machine learning algorithm by using the selected magnetic field data. This way is relatively fixed in data selection, a fixed number of magnetic field data is selected for calculation no matter whether magnetic field interference in an environment is serious, a fitting operation amount is large, and a certain calculation loss is caused, so that a calibration process of a compass is complicated. Or, a small number of magnetic field data is selected, and the elliptical magnetic field is fitted into the ideal spherical magnetic field through the magnetic field data as few as possible. In this way, although a calculation amount and the calculation loss can be reduced, an accurate sphere center coordinate cannot be obtained for an environment with serious magnetic field interference, resulting in poor accuracy of a compass calibration. Therefore, in the related art, when the compass is calibrated, different numbers of magnetic field data cannot be flexibly selected according to the magnetic field interference condition of the environment, resulting in a low calibration efficiency of the compass.

In view of this, the present invention provides a calibration method for an electronic compass, a calibration apparatus for an electronic compass, an electronic device and a medium, in which a target number of magnetic field data to be used during spherical magnetic field fitting is determined according to a magnetic field interference condition of an environment, and then, the spherical magnetic field fitting is performed according to the target number of magnetic field data, so as to calibrate the electronic compass, thereby improving a calibration efficiency of the electronic compass.

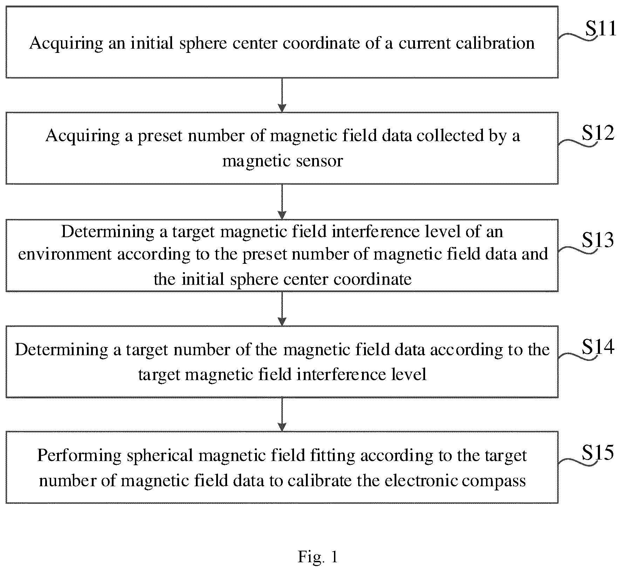

Fig. 1 shows a flow chart of a calibration method for an electronic compass according to an illustrative example. As shown in Fig. 1, the calibration method includes the following steps.

At step S11, an initial sphere center coordinate of a current calibration is acquired.

It should be understood that the electronic compass may be arranged on an electronic device (such as a mobile terminal), and may also be arranged on an unmanned vehicle or an unmanned aerial vehicle, which is not specifically limited in the present invention.

In the present invention, the initial sphere center coordinate of the current calibration is a sphere center coordinate of a spherical magnetic field at the start of the current calibration, and the spherical magnetic field may be an initially fitted spherical magnetic field or a spherical magnetic field fitted at a previous calibration. A manner in which the initial sphere center coordinate of the current calibration is determined is described in detail below.

At step S12, a preset number of magnetic field data collected by a magnetic sensor is acquired.

At step S13, a target magnetic field interference level of an environment is determined according to the preset number of magnetic field data and the initial sphere center coordinate.

It should be noted that the expression "a or the preset number of magnetic field data" herein refers to the magnetic field data whose quantity is the present number.

In the present invention, the electronic device, the unmanned vehicle, or the unmanned aerial vehicle where the electronic compass is located is mobile, and a magnetic field interference condition of the environment may also change at different moments. Thus, in order to guarantee accuracy of the determined target magnetic field interference level of the environment, the preset number of magnetic field data collected by the magnetic sensor in a current period is acquired. The period may be a calibration period of the electronic compass. For example, the calibration period is 5s, and the preset number of magnetic field data may be acquired from the magnetic field data collected by the magnetic sensor within 5s before a current moment.

For example, the magnetic sensor may be a magnetometer, the preset number may be N, and the N magnetic field data may be represented as: $(x_1, y_1, z_1)$, $(x_2, y_2, z_2)$, $(x_3, y_3, z_3)$ ... $(x_N, y_N, z_N)$.

The preset number of magnetic field data acquired in step S12 is used to determine the target magnetic field interference level of the environment, and in order to improve the accuracy of the determined target magnetic field interference level, more magnetic field data may be selected. That is, the preset number may be a larger number, e.g. 80, 100, or the like. Furthermore, in the present invention, the target magnetic field interference level of the environment refers to a current magnetic field interference level of the environment.

At step S14, a target number of the magnetic field data is determined according to the target magnetic field interference level.

It should be noted that the expression "a target number of the magnetic field data" herein refers to the quantity of the magnetic field data, i.e. the target number.

In the present invention, the target number of the magnetic field data is determined according to the target magnetic field interference level, and the higher the target magnetic field interference level, the larger the determined target number.

For example, a specific implementation of step S14 includes: determining the target number of the magnetic field data corresponding to the target magnetic field interference level according to a correspondence relationship between the magnetic field interference level and the number of the magnetic field data.

The correspondence relationship between the magnetic field interference level and the number of the magnetic field data is calibrated in advance. The higher the magnetic field interference level, the more serious the current interference of the environment, and the lower the accuracy of the magnetic field data collected by the magnetic sensor. In order to obtain an accurate spherical magnetic field and an accurate sphere center coordinate, more magnetic field data is required to be fitted. Therefore, in the present invention, in the correspondence relationship between the magnetic field interference level and the number of the magnetic field data, the higher the magnetic field interference level, the larger the corresponding number of the magnetic field data.

Furthermore, the magnetic field interference level may be set by a skilled person based on experiences. For example, the magnetic field interference level may be divided into three levels, for example, a first magnetic field interference level, a second magnetic field interference level, and a third magnetic field interference level. Similarly, the magnetic field interference level may also be divided into more or fewer levels.

It should be understood that the more the divided levels, the more accurate the fitted spherical magnetic field and sphere center coordinate, that is, the higher the accuracy of the calibration of the electronic compass, but the more complicated the calibration process of the electronic compass, and the more the workload for calibrating the correspondence relationship between the magnetic field interference level and the number of the magnetic field data. Therefore, different numbers of levels may be divided according to actual situations.

At step S 15, spherical magnetic field fitting is performed according to the target number of magnetic field data to calibrate the electronic compass.

It should be noted that the expression "the target number of magnetic field data" herein refers to the magnetic field data whose quantity is the target number.

Furthermore, the expression "a or the number of features" herein refers to the features whose quantity is this number, while the expression "a or the number of the features" herein refers to the quantity of the features, i.e. this number.

It should be understood that after the target number of magnetic field data is selected, the magnetic field fitting may be performed by using a nine-axis algorithm according to the target number of magnetic field data, an acceleration, and relevant data collected by a gyroscope, so as to calibrate the electronic compass. The nine-axis algorithm belongs to a mature technology, and is not repeated in the present invention.

With the above technical solution, firstly, the current target magnetic field interference level of the environment is determined according to the preset number of magnetic field data and the initial sphere center coordinate of the current calibration, and then, the corresponding target number of the magnetic field data is determined according to the target magnetic field interference level, and finally, the spherical magnetic field fitting is performed according to the target number of magnetic field data so as to calibrate the electronic compass. Thus, different numbers of magnetic field data is selected for the spherical magnetic field fitting according to different magnetic field interference levels, reducing a calculation loss. Further, the number of magnetic field data corresponding to the magnetic field interference level is adopted for fitting, which improves the accuracy of the spherical magnetic field fitting, thus improving the calibration efficiency of the electronic compass.

A specific implementation of acquisition of the initial sphere center coordinate of the current calibration is described below.

In an example, the current calibration is not a first calibration, and the initial sphere center coordinate of the current calibration is a target sphere center coordinate of a previous calibration. It should be understood that each calibration is performed according to the calibration method shown in Fig. 1, and the target sphere center coordinate of the previous calibration refers to a sphere center coordinate finally obtained in the previous calibration of the electronic compass.

In another example, the current calibration is a first calibration, and the initial sphere center coordinate of the first calibration may be determined in a following manner. Firstly, $n3 \cdot K2$ magnetic field data collected by the magnetic sensor is acquired, $n3 \cdot K2$ is greater than or equal to a target number corresponding to the highest magnetic field interference level, $n3$ is an integer greater than or equal to 4, and $K2$ is an integer. Then, the $n3 \cdot K2$ magnetic field data is grouped to obtain $K2$ third fitting data groups, and each third fitting data group includes at least 4 magnetic field data. For example, the $K2$ third fitting data groups may include the same number of magnetic field data. For example, each group includes $n3$ magnetic field data. For another example, the $K2$ third fitting data groups may include different numbers of magnetic field data. For example, $n3$ is 5, $K2$ is 3, and the numbers of the magnetic field data included by the three third fitting data groups may be 4, 5, and 6 respectively. It should be understood that in order to guarantee the accuracy of the determined initial sphere center coordinate of the first calibration, a value of $K2$ may be a large number, so that $n3 \cdot K2$ is greater than or equal to the target number corresponding to the highest magnetic field interference level.

Then, the spherical magnetic field fitting is performed on the magnetic field data included in each third fitting data group, so as to obtain $K2$ sphere center coordinates.

For example, assuming that each third fitting data group includes 4 magnetic field data, for each third fitting data group, the spherical magnetic field fitting is performed on the 4 magnetic field data included in the third fitting data group, so as to obtain the sphere center coordinate. For example, assuming that the 4 magnetic field data included in the third fitting data group are $(x_1, y_1, z_1)$, $(x_2, y_2, z_2)$, $(x_3, y_3, z_3)$ and $(x_4, y_4, z_4)$ respectively, the sphere center coordinate corresponding to the third fitting data group is $(x, y, z)$, and a radius of the spherical magnetic field fitted by the third fitting data group is $r$, the process of calculating the sphere center coordinate from the 4 magnetic field data is as follows, and the 4 magnetic field data is expressed as the following spherical formulas:

$$(x_1 - x)^2 + (y_1 - y)^2 + (z_1 - z)^2 = r^2$$

$$(x_2 - x)^2 + (y_2 - y)^2 + (z_2 - z)^2 = r^2$$

$$(x_3 - x)^2 + (y_3 - y)^2 + (z_3 - z)^2 = r^2$$

$$(x_4 - x)^2 + (y_4 - y)^2 + (z_4 - z)^2 = r^2 .$$

The above formulas are expanded and simplified to obtain the following formulas:

$$(x_1 - x_2)x + (y_1 - y_2)y + (z_1 - z_2)z = 1/2(x_1^2 - x_2^2 + y_1^2 - y_2^2 + z_1^2 - z_2^2)$$

$$(x_3 - x_4)x + (y_3 - y_4)y + (z_3 - z_4)z = 1/2(x_3^2 - x_4^2 + y_3^2 - y_4^2 + z_3^2 - z_4^2)$$

$$(x_2 - x_3)x + (y_2 - y_3)y + (z_2 - z_3)z = 1/2(x_2^2 - x_3^2 + y_2^2 - y_3^2 + z_2^2 - z_3^2) .$$

A determinant D and constant determinants P, Q, R corresponding to the above formulas are shown as follows:

$$D = \begin{bmatrix} a_1 & b_1 & c_1 \\ a_2 & b_2 & c_2 \\ a_3 & b_3 & c_3 \end{bmatrix}, \quad \begin{aligned} a_1 &= (x_1 - x_2), b_1 = (y_1 - y_2), c_1 = (z_1 - z_2) \\ a_2 &= (x_3 - x_4), b_1 = (y_3 - y_4), c_1 = (z_3 - z_4) \\ a_3 &= (x_2 - x_3), b_1 = (y_2 - y_3), c_1 = (z_2 - z_3) \end{aligned},$$

$$P = 1/2(x_1^2 - x_2^2 + y_1^2 - y_2^2 + z_1^2 - z_2^2)$$

$$Q = 1/2(x_3^2 - x_4^2 + y_3^2 - y_4^2 + z_3^2 - z_4^2)$$

$$R = 1/2(x_2^2 - x_3^2 + y_2^2 - y_3^2 + z_2^2 - z_3^2).$$

The above constant determinants P, Q, R are represented by the following matrixes:

$$Dx = \begin{bmatrix} P & b_1 & c_1 \\ Q & b_2 & c_2 \\ R & b_3 & c_3 \end{bmatrix} \quad Dy = \begin{bmatrix} a_1 & P & c_1 \\ a_2 & Q & c_2 \\ a_3 & R & c_3 \end{bmatrix} \quad Dz = \begin{bmatrix} a_1 & b_1 & P \\ a_2 & b_2 & Q \\ a_3 & b_3 & R \end{bmatrix}.$$

The calculated sphere center coordinate of the spherical magnetic field fitted by the third fitting data group is $x = Dx / D$, $y = Dy / D$, $z = Dz / D$, and the radius of the spherical magnetic field fitted by the third fitting data group is

$$r = \sqrt{(x_1 - x)^2 + (y_1 - y)^2 + (z_1 - z)^2}$$

. Thus, for each third fitting data group can be obtained, the sphere center coordinate corresponding to the third fitting data group can be obtained, and then, the K2 sphere center coordinates are obtained.

Finally, the K2 sphere center coordinates are taken as target coordinates, and a fitting operation is performed to obtain center coordinates. When the number of the center coordinates is still greater than or equal to n2, the center coordinates are determined as the target coordinates, and the fitting operation is re-performed until the number of the center coordinates is 1, and the center coordinate is determined as the initial sphere center coordinate of the first calibration, or until the number of the center coordinates is 2, and an average value of the center coordinates is determined as the initial sphere center coordinate of the first calibration.

A specific implementation of the fitting operation includes: grouping the target coordinates to obtain at least one second fitting data group, each second fitting data group including at least 3 target coordinates, and performing fitting according to the target coordinates included in each second fitting data group to obtain the center coordinates corresponding to every second fitting data group.

For example, assuming that n3 is 4 and K2 is 16, 16 sphere center coordinates can be obtained in the above manner, and then, the 16 sphere center coordinates are determined as the target coordinates, the 16 target coordinates are grouped to obtain 4 second fitting data groups, each second fitting data group includes 4 target coordinates, and the sphere center coordinate, i.e., the center coordinate, corresponding to each second fitting data group is calculated by referring to the above manner of calculating the sphere center coordinate, so as to obtain 4 center coordinates. The above fitting operation is performed again, the 4 center coordinates serve as one second fitting data group, one center coordinate is calculated by referring to the above manner of calculating the sphere center coordinate, and the center coordinate is determined as the initial sphere center coordinate of the first calibration.

It should be understood that the above description is given by taking determination of the initial sphere center coordinate of the first calibration from 64 magnetic field data as an example. In practical applications, the initial sphere center coordinate of the first calibration can also be determined from 48 magnetic field data. For example, when the initial sphere center coordinate of the first calibration is determined according to 48 magnetic field data, firstly, one sphere center coordinate is calculated from every 4 magnetic field data to obtain 12 sphere center coordinates, and then, the 12 sphere center coordinates are divided into 3 groups, each group includes 4 data, 3 sphere center coordinates can be obtained by using the above manner of calculating the sphere center coordinate, and finally, a circle center coordinate of a circumcircle of the 3 sphere center coordinates is obtained by calculating a circumcircle of a triangle for the 3 sphere center coordinates.

For example, assuming that the 3 sphere center coordinates are $(x_5, y_5, z_5)$, $(x_6, y_6, z_6)$, and $(x_7, y_7, z_7)$ respectively, the circle center coordinate of the circumcircle corresponding to the 3 sphere center coordinates is $(x_0, y_0, z_0)$, and a radius of the circumcircle is $r_0$, the process of calculating the circle center coordinate from the 3 sphere center coordinates is as follows, and the 3 sphere center coordinates are represented by the following matrix:

$$\begin{bmatrix} x_0 & y_0 & z_0 & 1 \\ x_5 & y_5 & z_5 & 1 \\ x_6 & y_6 & z_6 & 1 \\ x_7 & y_7 & z_7 & 1 \end{bmatrix} = 0.$$

The matrix is simplified to obtain the following formula: $A_1x_0 + B_1y_0 + C_1z_0 + D_1 = 0$, in which $A_1$, $B_1$, $C_1$ and $D_1$ can be represented as follows:

$$A_1 = y_5z_6 - y_5z_7 - z_5y_6 + z_5y_7 - y_7z_6$$

$$B_1 = -x_5z_6 + x_5z_7 + z_5x_6 - z_5x_7 - x_6z_7 + x_7z_6$$

$$C_1 = x_5y_6 - x_5y_7 - y_5x_6 + y_5x_7 + x_6y_7 - x_7y_6$$

$$D_1 = -x_5y_6z_7 + x_5y_7z_6 + x_6y_5z_7 - x_7y_5z_6 - x_6y_7z_5 + x_7y_6z_5$$

Distances between the 3 sphere center coordinates and the circle center can be expressed as follows:

$$r_0{}^2 = (x_5 - x_0)^2 + (y_5 - y_0)^2 + (z_5 - z_0)^2$$

$$r_0{}^2 = (x_6 - x_0)^2 + (y_6 - y_0)^2 + (z_6 - z_0)^2.$$

$$r_0{}^2 = (x_7 - x_0)^2 + (y_7 - y_0)^2 + (z_7 - z_0)^2$$

A formula $2(x_6 - x_5)x_0 + 2(y_6 - y_5)y_0 + 2(z_6 - z_5)z_0 + x_5{}^2 + y_5{}^2 + z_5{}^2 - x_6{}^2 - y_6{}^2 - z_6{}^2 = 0$ can be obtained from the above formulas and is recorded as $A_2x_0 + B_2y_0 + C_{12}z_0 + D_2 = 0$. A formula $2(x_7 - x_5)x_0 + 2(y_7 - y_5)y_0 + 2(z_7 - z_5)z_0 + x_5{}^2 + y_5{}^2 + z_5{}^2 - x_7{}^2 - y_7{}^2 - z_7{}^2 = 0$ is obtained and recorded as $A_3x_0 + B_3y_0 + C_3z_0 + D_3 = 0$.
Based on the above formulas, the following matrix is obtained:

$$\begin{bmatrix} A_1 & B_1 & C_1 \\ A_2 & B_2 & C_2 \\ A_3 & B_3 & C_3 \end{bmatrix} \begin{bmatrix} x_0 \\ y_0 \\ z_0 \end{bmatrix} + \begin{bmatrix} D_1 \\ D_2 \\ D_3 \end{bmatrix} = 0.$$

Thus, the calculated circle center coordinate is:

$$\begin{bmatrix} x_0 \\ y_0 \\ z_0 \end{bmatrix} = \begin{bmatrix} A_1 & B_1 & C_1 \\ A_2 & B_2 & C_2 \\ A_3 & B_3 & C_3 \end{bmatrix}^{-1} \begin{bmatrix} D_1 \\ D_2 \\ D_3 \end{bmatrix}.$$

The radius is $r_0 = \sqrt{(x_5 - x_0)^2 + (y_5 - y_0)^2 + (z_5 - z_0)^2}$.
It should be understood that the calculated circle center coordinate is the initial sphere center coordinate of the first calibration.
A specific implementation of step S13 of determining the target magnetic field interference level of the environment according to the preset number of magnetic field data and the initial sphere center coordinate in Fig. 1 is described below.
First, for each of the preset number of magnetic field data, a distance value between the magnetic field data and the initial sphere center coordinate is calculated. Then, the radius of the spherical magnetic field corresponding to the initial sphere center coordinate is acquired. When the current calibration is not the first calibration, the radius of the spherical magnetic field corresponding to the initial sphere center coordinate may be the radius of the spherical magnetic field fitted in the previous calibration. When the current calibration is the first calibration, the radius of the spherical magnetic field corresponding to the initial sphere center coordinate is the radius calculated in the example of determining the initial sphere center coordinate of the first calibration.
Finally, the target magnetic field interference level of the environment is determined according to the radius and the preset number of distance values.

In an example, the target magnetic field interference level of the environment may be determined according to a standard deviation of the radius and the preset number of distance values.

In yet another example, the target magnetic field interference level of the environment may be determined according to an average value of differences of the radius and the preset number of distance values.

In another example, an error value for estimating a spherical uniformity of the spherical magnetic field may be further calculated by the following formula, in which err represents the error value, N represents the preset number, $r_i$ represents an i-th distance value, and R represents the radius of the spherical magnetic field corresponding to the initial sphere center coordinate:

$$\text{err} = \sqrt{\sum_{i=1}^{N}(r_i - R)^2}.$$

A target error range in which the error value is located is determined, and the magnetic field interference level corresponding to the target error range is determined as the target magnetic field interference level of the environment.

In the example, error ranges corresponding to different magnetic field interference levels may be preset. For example, the error range corresponding to the first magnetic field interference level is set to be [0, err1), the error range corresponding to a second magnetic field interference level is set to be [err1, err2), and the error range corresponding to a third magnetic field interference level is set to be [err2, err3]. err1<err2<err3. When the error value determined according to the above formula is within [err1, err2), the target magnetic field interference level of the environment is determined to be the second magnetic field interference level.

Furthermore, when the error value is greater than an upper limit value of the error range corresponding to the highest magnetic field interference level, the electronic compass is calibrated according to the target sphere center coordinate of the previous calibration and a six-axis algorithm.

When the error value is greater than the upper limit value of the error range corresponding to the highest magnetic field interference level, for example, err is greater than err3, it indicates that the current magnetic field interference of the environment is serious, and an error of the magnetic field data collected by the magnetic sensor is relatively large. In this case, the magnetic field data collected by the magnetic sensor can be abandoned, and the electronic compass can be calibrated according to the sphere center coordinate of the spherical magnetic field calculated in the previous calibration and the six-axis algorithm.

In the present invention, the electronic compass may be calibrated periodically. The calibration periods may be the same or different for different magnetic field interference levels. In a case that the calibration periods are different for different magnetic field interference levels, the calibration period of the current calibration can be determined according to the target magnetic field interference level of the environment in the previous calibration, and the more serious the interference of the environment in the previous calibration, the smaller the calibration period of the current calibration. For example, when the target magnetic field interference level of the environment in the previous calibration is the first magnetic field interference level, the calibration period of the current calibration may be T1. When the target magnetic field interference level of the environment in the previous calibration is the second magnetic field interference level, the calibration period of the current calibration may be T2. When the target magnetic field interference level of the environment in the previous calibration is the third magnetic field interference level, the calibration period of the current calibration may be T3. T1 >T2>T3. It should be understood that the calibration period of the current calibration here may be understood as a time interval between the current calibration and the previous calibration.

In this way, the higher the target magnetic field interference level of the environment in the previous calibration, that is, the more serious the magnetic field interference, the shorter the calibration period of the electronic compass, and the higher the calibration frequency, thus improving the accuracy of the course measurement of the electronic compass.

Considering that at least 4 magnetic field data is required during the spherical magnetic field fitting, in the present invention, the target number is n1·K1, in which n1 is an integer greater than or equal to 4 and K1 is an integer greater than or equal to 1.

For example, it is assumed that the number of the magnetic field data corresponding to the first magnetic field interference level is 4, the number of the magnetic field data corresponding to the second magnetic field interference level is 12, and the number of the magnetic field data corresponding to the third magnetic field interference level is 48. When the target magnetic field interference level of the environment is determined to be the first magnetic field interference level, the corresponding target number is 4. When the target magnetic field interference level of the environment is determined to be the second magnetic field interference level, the corresponding target number is 12. When the target magnetic field interference level of the environment is determined to be the third magnetic field interference level, the corresponding target number is 48.

It should be understood that, in the above description, as an example, the magnetic field interference levels include three levels, and the numbers of the magnetic field data corresponding to the levels are 4, 12 and 48, and in practical applications, the magnetic field interference levels may include other numbers of levels, and the number of the magnetic field data corresponding to each level may also be another number, which is not specifically limited in the present invention.

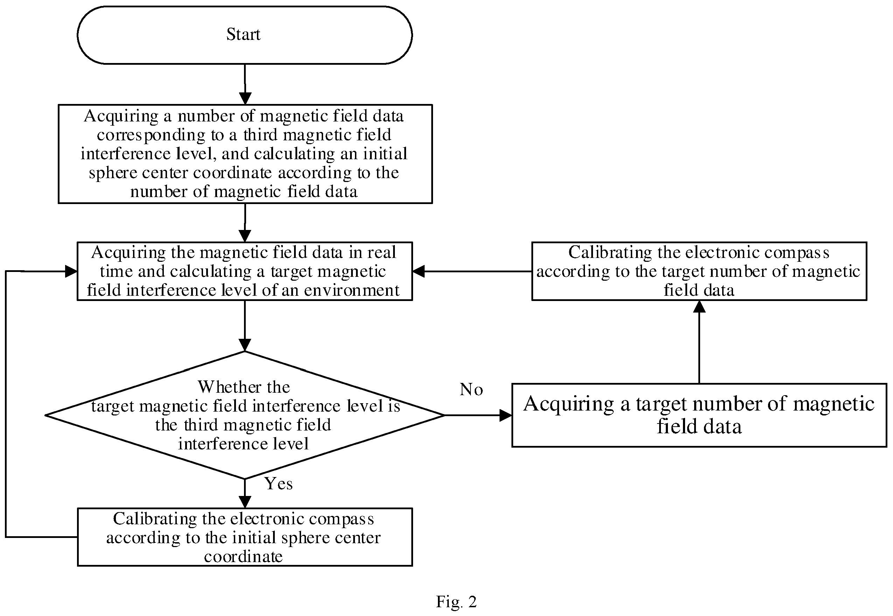

Fig. 2 shows a flow chart of another calibration method for an electronic compass according to an illustrative example. It is assumed that the number of the magnetic field data selected to determine the initial sphere center coordinate of the first calibration is the number of the magnetic field data corresponding to the third magnetic field interference level. As shown in Fig. 2, first, the number of magnetic field data corresponding to the third magnetic field interference level is acquired, and the initial sphere center coordinate is calculated according to the number of magnetic field data. Next, the magnetic field data is acquired in real time and the target magnetic field interference level of the environment is calculated. Then, it is judged whether the target magnetic field interference level is the third magnetic field interference level, and when yes, the calculated initial sphere center coordinate is the target sphere center coordinate of the current calibration. Therefore, the electronic compass is calibrated according to the initial sphere center coordinate. When the target magnetic field interference level is not the third magnetic field interference level, the target number of magnetic field data is acquired, and the electronic compass is calibrated according to the target number of magnetic field data.

A specific implementation of step S15 of performing the spherical magnetic field fitting according to the target number of magnetic field data to calibrate the electronic compass in Fig. 1 may be as follows.

First, the n1·K1 magnetic field data is grouped to obtain K1 first fitting data groups, and each first fitting data group includes at least 4 magnetic field data.

It should be understood that, during determination of the initial sphere center coordinate of the first calibration, n1·K2 magnetic field data is used, and considering that the magnetic field interference level of the environment is unknown, in order to guarantee the accuracy of the initial sphere center coordinate of the first calibration, the number of the initially used magnetic field data should be greater than the number of the magnetic field data used in each subsequent calibration. Therefore, the number n3 K2 of the magnetic field data used during determination of the initial sphere center coordinate of the first calibration is greater than or equal to the target number corresponding to the highest magnetic field interference level.

In the present invention, the manner of grouping the n1·K1 magnetic field data to obtain the K1 first fitting data groups is similar to the manner of grouping the n3·K2 magnetic field data to obtain the K2 third fitting data groups, and is not repeated herein.

Then, the spherical magnetic field fitting is performed according to the magnetic field data included in each first fitting data group, so as to obtain K1 sphere center coordinates.

The manner of performing the spherical fitting according to at least 4 data is described in the manner of determining the initial sphere center coordinate of the first calibration, and is not repeated herein.

When K1=1, the sphere center coordinate is determined as the target sphere center coordinate of the current calibration, and the electronic compass is calibrated according to the target sphere center coordinate.

For example, following the above example, when the target magnetic field interference level of the environment is the first magnetic field interference level, and the corresponding target number is 4, the spherical magnetic field fitting is performed on the 4 magnetic field data to obtain one sphere center coordinate. This sphere center coordinate is the target sphere center coordinate of the current calibration, and the electronic compass is calibrated according to the target sphere center coordinate. The technology for calibrating the electronic compass according to the sphere center coordinate belongs to a mature technology, and is not specifically limited in the present invention.

When K1=2, an average value of the sphere center coordinates is determined as the target sphere center coordinate of the current calibration, and the electronic compass is calibrated according to the target sphere center coordinate.

For example, when K1=2, the average value of the two sphere center coordinates is determined as the target sphere center coordinate of the current calibration.

Furthermore, when K1=2, any one of the sphere center coordinates may be directly determined as the target sphere center coordinate of the current calibration.

When K1 is greater than or equal to n2, the sphere center coordinates are determined as the target coordinates, and the following fitting operation is performed: grouping the target coordinates to obtain at least one second fitting data group, each second fitting data group including at least 3 target coordinates, and performing fitting according to the target coordinates included in each second fitting data group to obtain the center coordinates corresponding to every second fitting data group, and n2 being an integer greater than or equal to 3.

Finally, when the number of the center coordinates is still greater than or equal to n2, the center coordinates are determined as the target coordinates, and the fitting operation is re-performed until the number of the center coordinate is 1, and the center coordinate is determined as the target sphere center coordinate of the current calibration, or until the number of the center coordinates is 2, and an average value of the center coordinates is determined as the target sphere center coordinate of the current calibration, and the electronic compass is calibrated according to the target sphere center coordinate.

In the present invention, in addition to performing the spherical magnetic field fitting on the magnetic field data, circular fitting may be performed on the sphere center coordinate of the spherical magnetic field obtained by the preliminary fitting to obtain the circle center coordinate or the spherical fitting may be performed again on the sphere center coordinate of the spherical magnetic field obtained by the preliminary fitting to obtain the sphere center coordinate. Therefore, after the K1 sphere center coordinates are obtained by the preliminary fitting, it is judged whether K1 is greater than n2, and n2 is an integer greater than or equal to 3. It should be understood that when the correspondence relationship of the magnetic field interference level and the number of the magnetic field data is set, K1 may be set to be a multiple of 4 or a multiple of 3.

For example, following the above example, when the target magnetic field interference level of the environment is the third magnetic field interference level, the corresponding target number is 48. The 12 sphere center coordinates obtained after the preliminary spherical magnetic field fitting are determined as the target coordinates, and the 12 target coordinates are grouped. For example, first, the 12 target coordinates are divided into 3 second fitting data groups, and each second fitting data group includes 4 target coordinates. Then, the spherical magnetic field fitting is performed on each second fitting data group to obtain 3 sphere center coordinates. Finally, one circle center coordinate, i.e., the center coordinate, is obtained by calculating a circumcircle of a triangle for the 3 sphere center coordinates, this center coordinate is determined as the target sphere center coordinate of the current calibration, and the electronic compass is calibrated according to the target sphere center coordinate.

For another example, first, the 12 target coordinates are divided into 4 second fitting data groups, and each second fitting data group includes 3 target coordinates. Then, the circular fitting is performed on each second fitting data group to obtain 3 circle center coordinates, i.e., the center coordinates. At this point, the number of the center coordinates is equal to 3, the center coordinates are determined as the target coordinates, and the fitting operation is performed again. Specifically, the 3 target coordinates are subjected to the circular fitting to obtain one circle center coordinate, i.e., the center coordinate. Finally, the center coordinate is determined as the target sphere center coordinate of the current calibration, and the electronic compass is calibrated according to the target sphere center coordinate.

With the above technical solution, firstly, the spherical magnetic field fitting is carried out on the magnetic field data to obtain a plurality of sphere center coordinates, and then, the spherical magnetic field fitting or the circular fitting is carried out on the plurality of sphere center coordinates, so that the fitting can be carried out a plurality of times according to the magnetic field interference level, and thus the fitting flexibility and the calibration precision of the electronic compass are improved.

To improve the accuracy of the fitting, in the present invention, the plurality of data included in each first fitting data group and each second fitting data group satisfies at least one of the following constraints:

an angle between any two data is greater than a preset angle;
each data satisfies the following formula:

$$err_a \leq \left| \sqrt{\left(x_j - x'\right)^2 + \left(y_j - y'\right)^2 + \left(z_j - z'\right)^2} - R \right| < err_b.$$

A value range of j is [1, M], M is a total number of the data included in the first fitting data group and the second fitting data group, $(x_j, y_j, z_j)$ is j-th data in the M data, $(x', y', z')$ is the initial sphere center coordinate of the current calibration, R is the radius of the spherical magnetic field corresponding to the initial sphere center coordinate, $err_a$ is a lower limit value of the error range corresponding to the magnetic field interference level in the previous calibration, and $err_b$ is the upper limit value of the error range corresponding to the magnetic field interference level in the previous calibration.

In an example, the angle between any two data may be calculated as follows: assuming that the 3 data included in the second fitting data group are A(x1, y1, z1), B(x2, y2, z2), and C(x3, y3, z3), AC=(x3-x1, y3-y1, z3-z1)=(a, b, c), and BC=(x3-x2, y3-y2, z3-z2)=(a1, b1, c1). A cosine value of an included angle between AC and BC is shown by the following formula:

$$\cos(AC, BC) = \frac{AC \cdot BC}{|AC| \cdot |BC|} = \frac{a \cdot a1 + b \cdot b1 + c \cdot c1}{\left(\sqrt{a^2 + b^2 + c^2} + \sqrt{a1^2 + b1^2 + c1^2}\right)}.$$

Then, the included angle between AC and BC is obtained according to the cosine value.

For example, the preset angle may be 60°, 80°, 120°, or the like.

It should be understood that when the data is grouped in the process of determining the initial sphere center coordinate of the first calibration, the data included in each group may also satisfy the constraint that the angle between any two data is greater than the preset angle.

Therefore, the data is grouped according to the above constraint, and when the fitting is performed on the basis of each group of data, the fitting accuracy can be improved, thus further improving the calibration efficiency of the electronic compass.

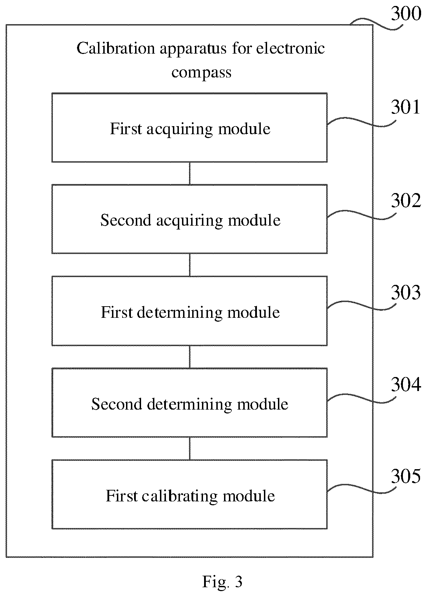

Based on the same inventive concept, the present invention further provides a calibration apparatus for an electronic compass. Fig. 3 shows a block diagram of a calibration apparatus 300 for an electronic compass according to an illustrative example. As shown in Fig. 3, the calibration apparatus 300 for the electronic compass may include: a first acquiring module 301 configured to acquire an initial sphere center coordinate of a current calibration; a second acquiring module 302 configured to acquire a preset number of magnetic field data collected by a magnetic sensor; a first determining module 303 configured to determine a target magnetic field interference level of an environment according to the preset number of magnetic field data and the initial sphere center coordinate; a second determining module 304 configured to determine a target number of the magnetic field data according to the target magnetic field interference level; and a first calibrating module 305 configured to perform spherical magnetic field fitting according to the target number of magnetic field data to calibrate the electronic compass.

In an example, the first determining module 303 includes: a distance value calculating submodule configured to, for each of the preset number of magnetic field data, calculate a distance value between the magnetic field data and the initial sphere center coordinate; a radius acquiring submodule configured to acquire a radius of a spherical magnetic field corresponding to the initial sphere center coordinate; and a level determining submodule configured to determine the target magnetic field interference level of the environment according to the radius and the preset number of distance values.

In an example, the level determining submodule is configured to: calculate an error value for estimating a spherical uniformity of the spherical magnetic field by the following formula, in which err represents the error value, N represents the preset number, $r_i$ represents an i-th distance value, and R represents the radius of the spherical magnetic

$$\text{err} = \sqrt{\sum_{i=1}^{N}(r_i - R)^2}$$

field corresponding to the initial sphere center coordinate: ; and determine a target error range in which the error value is located, and determine a magnetic field interference level corresponding to the target error range as the target magnetic field interference level of the environment.

In an example, the calibration apparatus 300 for the electronic compass further includes: a second calibrating module configured to calibrate the electronic compass according to a target sphere center coordinate of a previous calibration and a six-axis algorithm, when the error value is greater than an upper limit value of an error range corresponding to the highest magnetic field interference level.

In an example, the target number is n1·K1, n1 is an integer greater than or equal to 4 and K1 is an integer greater than or equal to 1.

In an example, the first calibrating module 305 includes: a grouping submodule configured to group the n1·K1 magnetic field data to obtain K1 first fitting data groups, each first fitting data group including at least 4 magnetic field data; a fitting submodule configured to perform the spherical magnetic field fitting according to the magnetic field data included in each first fitting data group, to obtain K1 sphere center coordinates; and a first determining submodule configured to determine the sphere center coordinate as a target sphere center coordinate of the current calibration, when K1=1, and calibrate the electronic compass according to the target sphere center coordinate.

In an example, the first calibrating module 305 further includes: a second determining submodule configured to determine an average value of the sphere center coordinates as the target sphere center coordinate of the current calibration, when K1=2, and calibrate the electronic compass according to the target sphere center coordinate.

In an example, the first calibrating module 305 further includes: a performing submodule configured to determine the sphere center coordinates as target coordinates, when K1 is greater than or equal to n2, and execute a following fitting operation: grouping the target coordinates to obtain at least one second fitting data group, each second fitting data group including at least 3 target coordinates, and performing fitting according to the target coordinates included in each second fitting data group to obtain center coordinates corresponding to every second fitting data group, n2 being an integer greater than or equal to 3; and a third determining submodule configured to determine the center coordinates as the target coordinates, when the number of the center coordinates is still greater than or equal to n2, and repeatedly perform the fitting operation until the number of the center coordinate is 1, and determine the center coordinate as the target sphere center coordinate of the current calibration, or until the number of the center coordinates is 2, and determine an average value of the center coordinates as the target sphere center coordinate of the current calibration, and calibrate the electronic compass according to the target sphere center coordinate.

In an example, the current calibration is a first calibration, and the calibration apparatus 300 for the electronic compass further includes: a third acquiring module configured to acquire n3 K2 magnetic field data collected by the magnetic sensor, n3 K2 being greater than or equal to the target number corresponding to the highest magnetic field interference level, n3 being an integer greater than or equal to 4, and K2 being an integer; a grouping module configured to group the n3·K2 magnetic field data to obtain K2 third fitting data groups, each third fitting data group including at least 4 magnetic field data; a fitting module configured to perform the spherical magnetic field fitting according to the magnetic field data included in each third fitting data group, to obtain K2 sphere center coordinates; a performing module configured to take the K2 sphere center coordinates as the target coordinates, and perform the fitting operation to obtain the center coordinates; and a fourth determining module configured to determine the center coordinates as the target coordinates, when the number of the center coordinates is still greater than or equal to n2, and re-perform the fitting operation until the number of the center coordinate is 1, and determine the center coordinate as the initial sphere center coordinate of the first calibration, or until the number of the center coordinates is 2, and determine an average value of the center coordinates as the initial sphere center coordinate of the first calibration.

In an example, the plurality of data included in each first fitting data group and each second fitting data group satisfy at least one of the following constraints:

an angle between any two data is greater than a preset angle;
each data satisfies the following formula:

$$ err_a \leq \left| \sqrt{(x_j - x')^2 + (y_j - y')^2 + (z_j - z')^2} - R \right| < err_b. $$

A value range of j is [1, M], M is a total number of the data included in the first fitting data group and the second fitting data group, $(x_j, y_j, z_j)$ is j-th data in the M data, $(x', y', z')$ is the initial sphere center coordinate of the current calibration, R is the radius of the spherical magnetic field corresponding to the initial sphere center coordinate, $err_a$ is a lower limit value of the error range corresponding to the magnetic field interference level in the previous calibration, and $err_b$ is the upper limit value of the error range corresponding to the magnetic field interference level in the previous calibration.

In an example, the second determining module 304 is configured to: determine the target number of the magnetic field data corresponding to the target magnetic field interference level according to a correspondence relationship between the magnetic field interference level and the number of the magnetic field data.

In an example, the current calibration is not the first calibration, and the initial sphere center coordinate of the current calibration is the target sphere center coordinate of the previous calibration.

With regard to the calibration apparatus 300 for the electronic compass according to the above example, a specific manner in which each module performs an operation is described in detail in the example of the method, and will not be described in detail here.

The present invention further provides a computer-readable storage medium storing computer program instructions thereon, and the program instructions, when executed by a processor, implement the steps of the calibration method for the electronic compass according to the present invention.

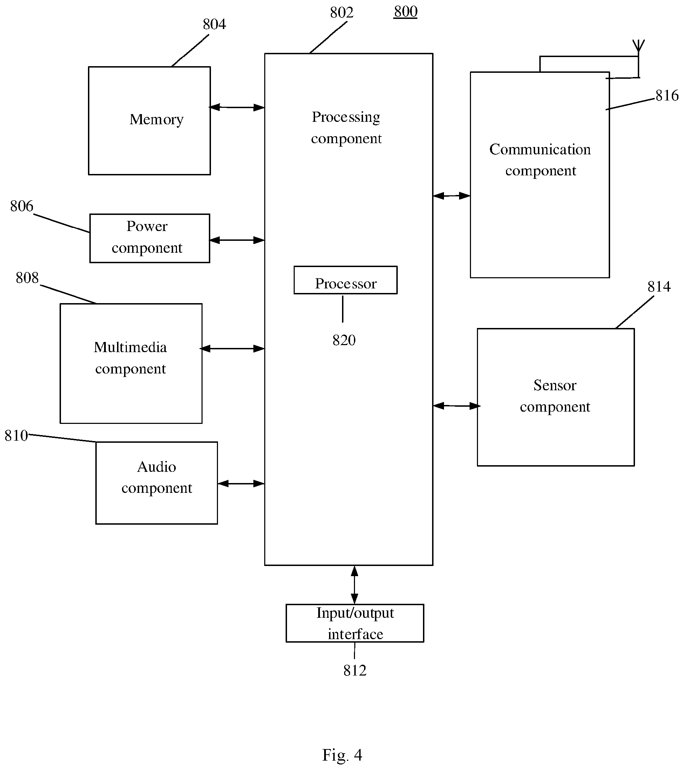

Fig. 4 shows a block diagram of an electronic device 800 according to an illustrative example. For example, the electronic device 800 may be a mobile phone, a computer, a digital broadcast terminal, a messaging device, a game console, a tablet device, a medical device, an exercise device, a personal digital assistant, or the like.

Referring to FIG. 4, the electronic device 800 may include one or more of the following components: a processing component 802, a memory 804, a power component 806, a multimedia component 808, an audio component 810, an input/output interface 812, a sensor component 814, and a communication component 816.

The processing component 802 usually controls overall operations of the electronic device 800, such as operations associated with display, telephone calls, data communication, camera operations, and recording operations. The processing component 802 may include one or more processors 820 to execute instructions to perform all or a part of the steps of the above method. Furthermore, the processing component 802 may include one or more modules facilitating interaction between the processing component 802 and other components. For example, the processing component 802 may include a multimedia module to facilitate interaction between the multimedia component 808 and the processing component 802.

The memory 804 is configured to store various types of data to support the operations at the electronic device 800. Examples of such data include instructions for any application or method operating on the electronic device 800, contact data, telephone book data, messages, pictures, videos, or the like. The memory 804 may be implemented by any type of volatile or non-volatile storage devices or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic disk or an optical disk.

The power component 806 provides power for the various components of the electronic device 800. The power component 806 may include a power management system, one or more power sources, and other components associated with generation, management, and distribution of power for the electronic device 800.

The multimedia component 808 includes a screen providing an output interface between the electronic device 800 and a user. In some examples, the screen may include a liquid crystal display (LCD) and a touch panel (TP). When the screen includes a touch panel, the screen may be implemented as a touch screen to receive an input signal from the user. The touch panel includes one or more touch sensors to sense a touch, a slide, and gestures on the touch panel. The touch sensor may not only sense a boundary of a touch or slide action, but also detect duration and pressure associated with a touch or slide operation. In some examples, the multimedia component 808 includes a front camera and/or a rear camera. The front camera and/or the rear camera may receive external multimedia data when the electronic device 800 is in an operational mode, such as a shooting mode or a video mode. Each of the front camera and the rear camera may be a fixed optical lens system or have a focal length and an optical zoom capability.

The audio component 810 is configured to output and/or input audio signals. For example, the audio component 810 includes a microphone (MIC) configured to receive external audio signals when the electronic device 800 is in an operational mode, such as a call mode, a recording mode, and a voice recognition mode. The received audio signal may be further stored in the memory 804 or transmitted by the communication component 816. In some examples, the audio component 810 further includes a loudspeaker for outputting audio signals.

The input/output interface 812 provides an interface between the processing component 802 and peripheral interface modules which may be keyboards, click wheels, buttons, or the like. These buttons may include, but are not limited to, a home button, a volume button, a start button, and a lock button.

The sensor component 814 includes one or more sensors for providing various aspects of state assessments for the electronic device 800. For example, the sensor component 814 may detect an on/off state of the electronic device 800, and relative positioning of components, such as a display and a keypad of the electronic device 800. The sensor component 814 may also detect a change in a position of the electronic device 800 or one component of the electronic device 800, presence or absence of contact between the user and the electronic device 800, an orientation or acceleration/deceleration of the electronic device 800, and a change in a temperature of the electronic device 800. The sensor component 814 may include a proximity sensor configured to detect presence of a nearby object in the absence of any physical contact. The sensor component 814 may also include a light sensor, such as a CMOS or CCD image sensor, for use in imaging applications. In some examples, the sensor component 814 may further include an acceleration sensor, a gyroscope sensor, a magnetic sensor, a pressure sensor, or a temperature sensor.

The communication component 816 is configured to facilitate wired or wireless communication between the electronic device 800 and other devices. The electronic device 800 may access a wireless network based on a communication standard, such as Wi-Fi, 2G, or 3G, 4G/LTE, 5G/NR or a combination thereof. In an illustrative example, the communication component 816 receives broadcast signals or broadcast related information from an external broadcast management system via a broadcast channel. In an illustrative example, the communication component 816 further includes a near field communication (NFC) module to facilitate short-range communication. For example, the NFC module may be implemented based on a radio frequency identification (RFID) technology, an infrared data association (IrDA) technology, an ultra wide band (UWB) technology, a Bluetooth (BT) technology, and other technologies.

In an illustrative example, the electronic device 800 may be implemented by one or more application specific integrated circuits (ASICs), digital signal processors (DSPs), digital signal processing devices (DSPDs), programmable logic devices (PLDs), field programmable gate arrays (FPGAs), controllers, micro-controllers, microprocessors, or other electronic elements for performing the above-mentioned method.

An illustrative example further provides a non-transitory computer-readable storage medium including instructions, such as the memory 804 including instructions, and the instructions are executable by the processor 820 of the electronic device 800 to perform the above method. For example, the non-transitory computer-readable storage medium may be a ROM, a random access memory (RAM), a CD-ROM, a magnetic tape, a floppy disk, an optical data storage device, or the like.

In another illustrative example, there is further provided a computer program product, which includes a computer program executable by a programmable apparatus, and the computer program has a code portion for performing the above calibration method for the electronic compass when executed by the programmable apparatus.

## Claims

1. A calibration method for an electronic compass, comprising:

    acquiring (S11) an initial sphere center coordinate of a current calibration;
    acquiring (S12) a preset number of magnetic field data collected by a magnetic sensor;
    determining (S13) a target magnetic field interference level of an environment according to the preset number of magnetic field data and the initial sphere center coordinate;
    determining (S14) a target number of the magnetic field data according to the target magnetic field interference level; and

performing (S15) spherical magnetic field fitting according to the target number of magnetic field data to calibrate the electronic compass.

2. The calibration method according to claim 1, wherein the determining (S13) the target magnetic field interference level of the environment according to the preset number of magnetic field data and the initial sphere center coordinate comprises:

for each of the preset number of magnetic field data, calculating a distance value between the magnetic field data and the initial sphere center coordinate;
acquiring a radius of a spherical magnetic field corresponding to the initial sphere center coordinate; and
determining the target magnetic field interference level of the environment according to the radius and the preset number of distance values.

3. The calibration method according to claim 2, wherein the determining the target magnetic field interference level of the environment according to the radius and the preset number of distance values comprises:

calculating an error value for estimating a spherical uniformity of the spherical magnetic field by a following formula, wherein err represents the error value, N represents the preset number, $r_i$ represents an i-th distance value, and R represents the radius of the spherical magnetic field corresponding to the initial sphere center coordinate:

$$\text{err} = \sqrt{\sum_{i=1}^{N}(r_i - R)^2};$$

and
determining a target error range where the error value is located, and determining a magnetic field interference level corresponding to the target error range as the target magnetic field interference level of the environment.

4. The calibration method according to claim 3, further comprising:
calibrating the electronic compass according to a target sphere center coordinate of a previous calibration and a six-axis algorithm, in response to determining that the error value is greater than an upper limit value of an error range corresponding to a highest magnetic field interference level.

5. The calibration method according to any one of claims 1 to 4, wherein the target number is n1·K1, n1 is an integer greater than or equal to 4 and K1 is an integer greater than or equal to 1.

6. The calibration method according to claim 5, wherein the performing (S15) the spherical magnetic field fitting according to the target number of magnetic field data to calibrate the electronic compass comprises:

grouping the n1·K1 magnetic field data to obtain K1 first fitting data groups, each first fitting data group comprising at least 4 magnetic field data of the n1·K1 magnetic field data;
performing the spherical magnetic field fitting according to the magnetic field data comprised in each first fitting data group, to obtain K1 sphere center coordinates; and
in response to determining that K 1 = 1, determining the sphere center coordinate as a target sphere center coordinate of the current calibration, and calibrating the electronic compass according to the target sphere center coordinate.

7. The calibration method according to claim 6, wherein the performing (S15) the spherical magnetic field fitting according to the target number of magnetic field data to calibrate the electronic compass further comprises:
in response to determining that K1=2, determining an average value of the sphere center coordinates as the target sphere center coordinate of the current calibration, and calibrating the electronic compass according to the target sphere center coordinate.

8. The calibration method according to claim 7, wherein the performing (S15) the spherical magnetic field fitting according to the target number of magnetic field data to calibrate the electronic compass further comprises:

in response to determining that K1 is greater than or equal to n2, determining the sphere center coordinates as target coordinates, and executing a following fitting operation: grouping the target coordinates to obtain at least one second fitting data group, each second fitting data group comprising at least 3 target coordinates, and performing fitting according to the target coordinates comprised in each second fitting data group to obtain center coordinates corresponding to every second fitting data group, n2 being an integer greater than or equal to 3; and in response to determining that a number of the center coordinates is still greater than or equal to n2, determining the center coordinates as the target coordinates, and repeatedly performing the fitting operation until the number of the center coordinate is 1, and determining the center coordinate as the target sphere center coordinate of the current calibration, or until the number of the center coordinates is 2, and determining an average value of the center coordinates as the target sphere center coordinate of the current calibration, and calibrating the electronic compass according to the target sphere center coordinate.

9. The calibration method according to claim 8, wherein the current calibration is a first calibration, and the initial sphere center coordinate of the first calibration is determined by:

acquiring n3·K2 magnetic field data collected by the magnetic sensor, n3·K2 being greater than or equal to the target number corresponding to a highest magnetic field interference level, n3 being an integer greater than or equal to 4, and K2 being an integer;
grouping the n3·K2 magnetic field data to obtain K2 third fitting data groups, each third fitting data group comprising at least 4 magnetic field data;
performing the spherical magnetic field fitting according to the magnetic field data comprised in each third fitting data group, to obtain K2 sphere center coordinates;
taking the K2 sphere center coordinates as the target coordinates, and performing the fitting operation to obtain the center coordinates; and
in response to determining that the number of the center coordinates is still greater than or equal to n2, determining the center coordinates as the target coordinates, and re-performing the fitting operation until the number of the center coordinate is 1, and determining the center coordinate as the initial sphere center coordinate of the first calibration, or until the number of the center coordinates is 2, and determining an average value of the center coordinates as the initial sphere center coordinate of the first calibration.

10. The calibration method according to claim 8 or 9, wherein a plurality of data comprised in each first fitting data group and each second fitting data group satisfies at least one of following constraints:

an angle between any two data is greater than a preset angle;
each data satisfies a following formula:

$$err_a \leq \left| \sqrt{(x_j - x')^2 + (y_j - y')^2 + (z_j - z')^2} - R \right| < err_b,$$

wherein a value range of j is [1, M], M is a total number of the data comprised in the first fitting data group and the second fitting data group, $(x_j, y_j, z_j)$ is j-th data in the M data, $(x', y', z')$ is the initial sphere center coordinate of the current calibration, R is a radius of a spherical magnetic field corresponding to the initial sphere center coordinate, $err_a$ is a lower limit value of an error range corresponding to a magnetic field interference level in a previous calibration, and $err_b$ is an upper limit value of the error range corresponding to the magnetic field interference level in the previous calibration.

11. The calibration method according to any one of claims 1 to 10, wherein the determining (S14) the target number of the magnetic field data according to the target magnetic field interference level comprises:
determining the target number of the magnetic field data corresponding to the target magnetic field interference level according to a correspondence relationship between a magnetic field interference level and a number of the magnetic field data.

12. The calibration method according to any one of claims 1 to 11, wherein the current calibration is not a first calibration, and the initial sphere center coordinate of the current calibration is a target sphere center coordinate of a previous calibration.

13. An electronic device (800), comprising:

a processor (820); and

a memory (804) configured to store instructions executable by the processor (820),

wherein the processor (820) is configured to execute steps of a calibration method according to any one of claims 1 to 12.

**14.** A computer-readable storage medium, storing computer program instructions thereon, wherein when executed by a processor (820), the program instructions are configured to implement steps of a calibration method according to any one of claims 1 to 12.

Acquiring an initial sphere center coordinate of a current calibration ⟿ S11

↓

Acquiring a preset number of magnetic field data collected by a magnetic sensor ⟿ S12

↓

Determining a target magnetic field interference level of an environment according to the preset number of magnetic field data and the initial sphere center coordinate ⟿ S13

↓

Determining a target number of the magnetic field data according to the target magnetic field interference level ⟿ S14

↓

Performing spherical magnetic field fitting according to the target number of magnetic field data to calibrate the electronic compass ⟿ S15

Fig. 1

```
                    ┌─────────────────────────┐
                    │          Start          │
                    └─────────────────────────┘
                                 │
                                 ▼
        ┌──────────────────────────────────────────────┐
        │   Acquiring a number of magnetic field data   │
        │   corresponding to a third magnetic field     │
        │   interference level, and calculating an      │
        │   initial sphere center coordinate according  │
        │   to the number of magnetic field data        │
        └──────────────────────────────────────────────┘
```

Acquiring the magnetic field data in real time and calculating a target magnetic field interference level of an environment

Calibrating the electronic compass according to the target number of magnetic field data

Whether the target magnetic field interference level is the third magnetic field interference level

No

Acquiring a target number of magnetic field data

Yes

Calibrating the electronic compass according to the initial sphere center coordinate

Fig. 2

Fig. 3

804

802    800

Memory

Processing
component

Communication
component

816

806

Power
component

Processor

808

820

Multimedia
component

814

810

Sensor
component

Audio
component

Input/output
interface

812

Fig. 4

Europäisches
Patentamt

European
Patent Office

Office européen
des brevets

# EUROPEAN SEARCH REPORT

**Application Number**

EP 23 20 4556

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/033818 A1 (KITAMURA TORU [JP] ET AL) 15 February 2007 (2007-02-15) | 1-5, 11-14 | INV.<br>G01R33/00 |
| A | * paragraphs [0056] - [0089]; figures 3-7 * | 6-10 | G01C17/38 |
| A | US 2007/288166 A1 (OCKERSE HAROLD C [US] ET AL) 13 December 2007 (2007-12-13)<br>* paragraphs [0134] - [0141], [0153] - [0219]; figures 11,12A-12C * | 1-14 | |
| A | US 2016/273915 A1 (KITAMURA TORU [JP] ET AL) 22 September 2016 (2016-09-22)<br>* paragraphs [0094] - [0097], [0113] - [0115], [0146] - [0148]; figures 1,12,19,23 * | 1-14 | |
| A | US 2021/072335 A1 (DERVISOGLU GUNES [US] ET AL) 11 March 2021 (2021-03-11)<br>* paragraphs [0005], [0006], [0031], [0032], [0059] * | 1-14 | |

| TECHNICAL FIELDS SEARCHED (IPC) |
|---|
| G01R |

The present search report has been drawn up for all claims

| Place of search | Date of completion of the search | Examiner |
|---|---|---|
| The Hague | 8 April 2024 | Bruinsma, Maarten |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 20 4556

This annex lists the patent family members relating to the patent documents cited in the above-mentioned European search report.
The members are as contained in the European Patent Office EDP file on
The European Patent Office is in no way liable for these particulars which are merely given for the purpose of information.

08-04-2024

| Patent document cited in search report | | | Publication date | Patent family member(s) | | | Publication date |
|---|---|---|---|---|---|---|---|
| US 2007033818 | A1 | | 15-02-2007 | AT | E504804 | T1 | 15-04-2011 |
| | | | | CN | 1816730 | A | 09-08-2006 |
| | | | | EP | 1643212 | A1 | 05-04-2006 |
| | | | | JP | 4644126 | B2 | 02-03-2011 |
| | | | | JP | WO2005003683 | A1 | 20-09-2007 |
| | | | | KR | 20060036078 | A | 27-04-2006 |
| | | | | KR | 20080106990 | A | 09-12-2008 |
| | | | | US | 2007033818 | A1 | 15-02-2007 |
| | | | | WO | 2005003683 | A1 | 13-01-2005 |
| US 2007288166 | A1 | | 13-12-2007 | CA | 2514154 | A1 | 10-09-2004 |
| | | | | EP | 1604171 | A2 | 14-12-2005 |
| | | | | KR | 20050113192 | A | 01-12-2005 |
| | | | | MX | PA05008700 | A | 05-10-2005 |
| | | | | US | 2004254727 | A1 | 16-12-2004 |
| | | | | US | 2007124076 | A1 | 31-05-2007 |
| | | | | US | 2007288166 | A1 | 13-12-2007 |
| | | | | WO | 2004076971 | A2 | 10-09-2004 |
| US 2016273915 | A1 | | 22-09-2016 | CN | 104204734 | A | 10-12-2014 |
| | | | | EP | 2816325 | A1 | 24-12-2014 |
| | | | | JP | 5712333 | B2 | 07-05-2015 |
| | | | | JP | WO2014141631 | A1 | 16-02-2017 |
| | | | | US | 2016273915 | A1 | 22-09-2016 |
| | | | | WO | 2014141631 | A1 | 18-09-2014 |
| US 2021072335 | A1 | | 11-03-2021 | NONE | | | |

EPO FORM P0459

For more details about this annex : see Official Journal of the European Patent Office, No. 12/82